Europäisches Patentamt

European Patent Office

Office européen des brevets

(19)

(11) **EP 0 513 185 B1**

(12) **EUROPEAN PATENT SPECIFICATION**

(45) Date of publication and mention
of the grant of the patent:
**11.06.1997 Bulletin 1997/24**

(21) Application number: **91904230.9**

(22) Date of filing: **22.01.1991**

(51) Int Cl.$^6$: **H01L 29/423**, H01L 29/78

(86) International application number:
**PCT/US91/00396**

(87) International publication number:
**WO 91/11826 (08.08.1991 Gazette 1991/18)**

(54) **MOSFET STRUCTURE HAVING REDUCED GATE CAPACITANCE AND METHOD OF FORMING SAME**

MOSFET-STRUKTUR MIT VERMINDERTER STEUERELEKTRODENKAPAZITÄT UND HERSTELLUNGSVERFAHREN

STRUCTURE DE TRANSISTOR A EFFET DE CHAMP DE TECHNOLOGIE MOS A CAPACITANCE DE GRILLE REDUITE ET METHODE DE FABRICATION

(84) Designated Contracting States:
**AT BE CH DE DK ES FR GB GR IT LI LU NL SE**

(30) Priority: **01.02.1990 US 473504**

(43) Date of publication of application:
**19.11.1992 Bulletin 1992/47**

(73) Proprietor: **QUIGG, Fred, L.**
**Thousand Oaks, CA 91360 (US)**

(72) Inventor: **QUIGG, Fred, L.**
**Thousand Oaks, CA 91360 (US)**

(74) Representative: **Fieret, Johannes, Ir. et al**
**Algemeen Octrooibureau,**
**World Trade Center,**
**P.O. Box 645**
**5600 AP Eindhoven (NL)**

(56) References cited:
EP-A- 0 050 773          EP-A- 0 069 429
EP-A- 0 211 972          JP-A-58 153 368
US-A- 4 290 077          US-A- 4 455 565
US-A- 4 969 020

- **IEE PROCEEDINGS I. SOLID-STATE & ELECTRON DEVICES vol. 132, no.6, December 1985, STEVENAGE GB pages 261-263**

## Description

<u>FIELD OF THE INVENTION</u>

This invention relates to metal-oxide-semiconductor field effect transistors (MOSFETs) and, in particular, to an improved structure of a MOSFET having reduced gate capacitance and increased switching speed.

<u>BACKGROUND OF THE INVENTION</u>

It is generally desirable to construct electrical circuits capable of high speed operation. In an electrical circuit containing MOSFETs, this requires the MOSFETs themselves to have rapid response to input signals. A significant barrier to achieving higher operating speeds of MOSFETs has been overcoming the parasitic gate capacitance of the MOSFET, where a significant amount of delay is incurred while charging and discharging the gate of the MOSFET to a certain voltage in order to amplify a signal or to fully switch the MOSFET on and off.

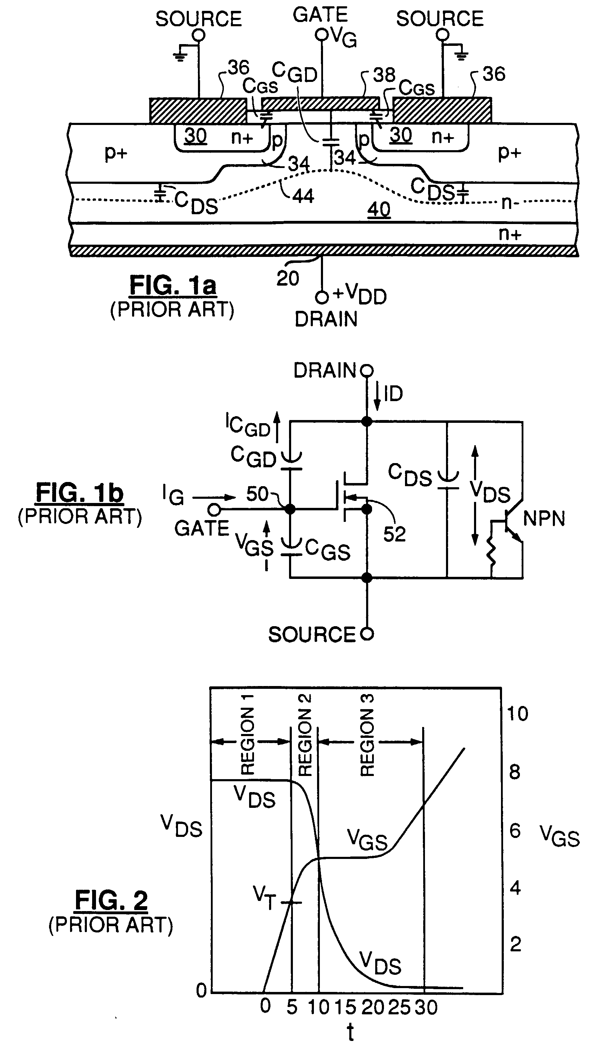

Fig. 1a shows a representative vertical MOSFET with the gate-source parasitic capacitance ($C_{GS}$) and the gate-drain parasitic capacitance ($C_{GD}$) shown. Also shown in Fig. 1a is the drain-source parasitic capacitance ($C_{DS}$).

To operate the N channel MOSFET of Fig. 1a, a positive voltage $V_{DD}$ is applied to drain terminal 20, while a low voltage (e.g., ground) is applied to source regions 30 and body regions 34. Source regions 30 and body regions 34, which constitute the emitter and base of a parasitic NPN bipolar transistor, are imperfectly shorted together by contacts 36 to prevent these regions from being forward biased. Conductive gate 38 is insulated from source regions 30 and body regions 34 by a gate oxide. When a gate-source voltage $V_{GS}$ is applied to gate 38 which exceeds the threshold voltage $V_T$ of the MOSFET, an ohmic channel forms in body regions 34 under gate 38 so as to ohmically couple N-type source regions 30 to N-type drain 40. Current is then conducted between source contacts 36 and drain terminal 20. When the MOSFET is in its off state, a depletion region, represented by dashed outline 44, is created within drain 40.

A basic equivalent circuit for the MOSFET of Fig. 1a is shown in Fig. 1b. As shown in Fig. 1b, for the gate 50 to have a voltage $V_G$ necessary to fully turn on MOSFET 52, both $C_{GS}$ and $C_{GD}$ must be fully charged. Capacitance $C_{DS}$ will be considered herein to approximate zero. Also shown in Fig. 1b is input gate current $I_G$ and current $I_{C_{GD}}$ charging capacitor $C_{GD}$. Note that source region 30, body region 34, and drain 40 form a parasitic NPN bipolar transistor within the MOSFET, as shown in Fig. 1b.

A vertical MOSFET, such as shown in Fig. 1a, is typically a polysilicon gate device, where the gate 38 is used as a diffusion mask to self-align source regions 30 and body regions 34.

Fig. 2 illustrates the voltage conditions during a dynamic switching operation for a representative MOSFET showing the effects of the charging of capacitances $C_{GS}$ and $C_{GD}$ with a constant current $I_G$ applied at t = 0. In region 1 of the graph of Fig. 2, the MOSFET is off, with $V_{GS}$ below the threshold voltage $V_T$. Input gate current $I_G$ is shared between $C_{GD}$ and $C_{GS}$ according to their capacitance ratio. Within region 2, the threshold voltage $V_T$ is reached and the MOSFET begins to turn on, lowering the drain-to-source voltage $V_{DS}$. This changing $V_{DS}$ sets up a condition where the voltage is changing more rapidly across $C_{GD}$ than $C_{GS}$. Current increases in $C_{GD}$ and decreases in $C_{GS}$, thus reducing the rate at which $V_{GS}$ is increasing. As $V_{GS}$ becomes larger, the dv/dt of the drain-to-source voltage $V_{DS}$ increases until the current $I_{C_{GD}}$ charging $C_{GD}$ reaches a magnitude equal to $I_G$, and $V_{GS}$ no longer increases. This condition results in the flat portion of the $V_{GS}$ curve in region 3 of Fig. 2.

During this time, the depletion region under the gate, generally shown as depletion region 44 in Fig. 1a, decreases since the potential of drain 40 under gate 38 is lowered due to this region being pulled down by the increasing ohmic channel between N-type source region 30 and N-type drain 40. During the entire turn-on period of the MOSFET, capacitance $C_{GD}$ is increasing due to this narrowing of the effective insulation between the plates of the equivalent capacitor $C_{GD}$. As this capacitance increases, a decreasing dv/dt of the drain-to-source voltage $V_{DS}$ results. This increase in capacitance $C_{GD}$ is reflected in the curved lower portion of $V_{DS}$ shown in Fig. 2.

Once capacitance $C_{GD}$ has stabilized, the MOSFET is essentially fully on, and $C_{GD}$ does not cause any further switching delay.

As seen by the gate charge characteristics of Fig. 2, the delay in switching of the MOSFET is significantly affected by capacitance $C_{GD}$, where capacitance $C_{GD}$ is more commonly referred to as the reverse transfer capacitance ($C_{rss}$). Since, as shown in Fig. 2, capacitance $C_{GD}$ is affected by voltage changes at the drain, it becomes understandable how the effective total gate capacitance ($C_{in}$) of the MOSFET under dynamic conditions is calculated using the following equation:

$$C_{in} = C_{GS} + C_{GD} (1 - A_V), \qquad \text{(eq. 1)}$$

where $A_V = dV_{DS}/dV_{GS}$. For an N channel MOSFET, $dV_{DS}$ will be a negative value, and for a P channel MOSFET, $dV_{GS}$ will be a negative value. Thus, in either case, $(1-A_V)$ is equal to (1 + voltage gain).

It is also to be noted that essentially the same gate charge characteristics are encountered with the discharging of the gate, which causes the turn-off speed of the MOSFET to be delayed. In linear applications, such as radio frequency (RF) power amplification, input capacitance largely determines the upper frequency limit of the MOSFET.

Typically, the value $C_{GD}$ $(1-A_V)$ is at least three times greater than $C_{GS}$, and thus any reduction of capacitance $C_{GD}$ will significantly lower the switching time of the MOSFET, or significantly raise the usable operating frequency.

Capacitance is calculated using the equation:

$$C = AKe_0/t, \text{ where} \qquad \text{(eq. 2)}$$

$C$ is the capacitance;
$e_0$ is the permittivity of empty space (8.85 x $10^{-2}$ $coul^2/newton^2$-$m^2$) ;
$K$ is the dielectric constant (3.9 for $SiO_2$ and 11.7 for Si);
$A$ is the plate area; and
$t$ is the dielectric thickness.

Thus, capacitance may be reduced by decreasing the plate area or increasing the dielectric thickness.

The prior art has attempted to reduce the parasitic gate capacitance of a MOSFET by reducing the area of the gate and/or increasing the effective dielectric thickness between the gate and the drain.

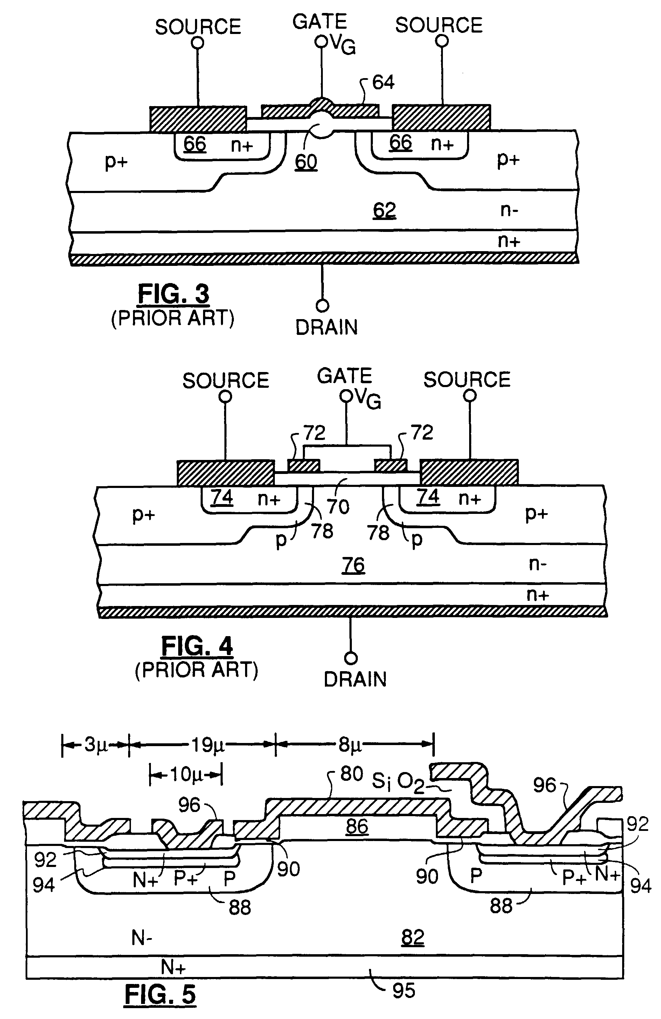

Two types of approaches which have been previously used to reduce $C_{GD}$ are shown in Figs. 3 and 4 where, in Fig. 3, an increased thickness of dielectric 60 is formed over drain 62 to provide an increased dielectric thickness between gate 64 and drain 62. The gate-source capacitance $C_{GS}$ is essentially unchanged, since the thickness of the dielectric separating gate 64 from source region 66 is essentially unchanged.

Prior art Fig. 4 illustrates an approach where an N channel vertical MOSFET uses two separate gates 70 and 72 commonly connected to a gate voltage $V_G$. Since the effective area of the gate over drain 76 is decreased, the $C_{GD}$ is also decreased.

One drawback of the MOSFET of prior art Fig. 3 is that gate 64 may be misaligned with respect to raised dielectric portion 60, causing part of the device to have low gain. In Fig. 4, a center portion of the gate oxide 70 over drain 76 must be masked and protected while body regions 78 and source regions 74 are formed self-aligned with the gate. Also in Fig. 4, the width of gate elements 72 is subject to mask and photoresist variations, which cause variations in $C_{GD}$ across a wafer and from lot to lot. The critical masking steps required to form raised dielectric portion 60 in Fig. 3 and to perform the precise etching of the gate in Fig. 4 require a relatively precise alignment of the mask, or relatively precise process and mask control, thus inevitably resulting in lower yields and variable performance devices.

Another drawback to the MOSFET in Fig. 3 is the imperfect short across the emitter-base of the parasitic bipolar transistor. Under certain adverse conditions, the bipolar transistor may be turned on to the extent of causing secondary breakdown and device failure. Manufacturers have addressed this problem by: 1) reducing the depth of the N+ source diffusion to lower beta; 2) moving the P+ body contact region closer to the channel region to reduce resistance between the emitter and base; and 3) reducing the lateral dimension of the N+ source region to lower the resistance between the emitter and base.

What is needed in the art is a MOSFET structure having a relatively low $C_{GD}$ and an inoperative parasitic bipolar transistor which may be formed with self-aligned source, body, and body contact regions and which may be formed without requiring numerous and difficult process steps.

US-A-4 455 565 discloses a vertical MOSFET including source and gate electrodes on a major semiconductor surface, and a drain electrode on an opposing semiconductor surface, and a shield electrode is disposed in proximity to the gate electrode so as to minimize feedback capacitance between the gate electrode and drain region.

EP-A-0 050 773 discloses a MOSFET having a drain of a first conductivity type formed in contact with a substrate of said first conductivity type, a P type body region formed in a surface region of the substrate and a source region formed in the body region such that the peripheral portion of the body region forms a channel region above which an insulated gate electrode is formed. In this prior art MOSFET the input capacitance is reduced in that the gate electrode over the drain area has a larger distance from the surface of the semiconductor body than over the channel area or is completely interrupted at that location.

## SUMMARY OF THE INVENTION

The above-described disadvantages of the prior art MOSFETS have been overcome by the invention defined in the attached claims. In accordance with one embodiment of the invention, a vertical MOSFET is formed having a lower gate portion overlying the channel region of the MOSFET and separated from the channel region by a thin gate oxide layer. An upper gate portion is formed overlying the drain of the MOSFET and separated from the drain by a relatively thick self-aligned oxide layer. In this particular embodiment, since the dielectric thickness between the upper gate portion and the drain is relatively large, the MOSFET exhibits a lower gate-drain capacitance ($C_{GD}$) value, while the threshold voltage of the MOSFET remains relatively unchanged. The upper gate portion is electrically isolated from the lower gate portion. A separate gate voltage may be connected to the upper gate portion to allow the upper gate portion to either act as a field plate or act to augment the fields generated by the lower gate portion to enhance the current handling capabilities of the MOSFET. A preferred method of forming the resulting MOSFET having this lowered $C_{GD}$ allows the source and body regions to be precisely aligned with the drain edge of the lower gate portion, and allows an ion implant damaged body contact region to be formed directly under, and self-aligned to, the source region, which ensures the parasitic bipolar transistor remains inoperative.

## BRIEF DESCRIPTION OF THE DRAWINGS

Fig. 1a illustrates a prior art vertical MOSFET.

Fig. 1b is a schematic diagram illustrating an equivalent circuit for the MOSFET of Fig. 1a.

Fig. 2 is a graph showing representative gate charge characteristics of a MOSFET.

Fig. 3 illustrates a first prior art MOSFET having reduced gate-drain capacitance.

Fig. 4 illustrates a second prior art MOSFET having reduced gate-drain capacitance.

Fig. 5 illustrates an example wherein a MOSFET for very high frequency (VHF) operation is made to have a relatively low $C_{GD}$.

Figs. 6-12 illustrate various process steps used for forming the VHF MOSFET of Fig. 5.

Fig. 13 illustrates another example of a MOSFET capable of ultra high frequency (UHF) operation having a low $C_{GD}$ where upper and lower gates are formed.

Fig. 14 illustrates the MOSFET of Fig. 13 with an upper gate coupled to source voltage.

Fig. 15 illustrates a MOSFET having a low $C_{GD}$ where an upper gate is removed.

Fig. 16a illustrates a MOSFET capable of UHF to super high frequency (SHF) operation having a very low $C_{GD}$ where a lower gate and an upper gate terminate over a portion of the channel region.

Fig. 16b illustrates with dashed lines the improved gate charge characteristics of the MOSFET of Fig. 16a.

Figs. 17 and 18 illustrate process steps used to form the MOSFET of Fig. 16.

Fig. 19 illustrates a MOSFET having a very low $C_{GD}$ which utilizes an overhanging upper gate to eliminate etching of a vertical portion of the gate.

Fig. 20 illustrates a process step used to form the MOSFET of Fig. 19.

Fig. 21 illustrates an embodiment of a MOSFET having a low $C_{GD}$ in accordance with the present invention which utilizes a split upper gate.

Fig. 22 illustrates a MOSFET having a low $C_{GD}$ which utilizes separate gates overlying an oxide layer of a single thickness.

Fig. 23 shows a schematic representation of a MOSFET having an upper gate and a lower gate.

Fig. 24 illustrates a lateral MOSFET having a low $C_{GD}$.

## DETAILED DESCRIPTION OF PREFERRED EMBODIMENTS

Fig. 5 shows an example of a MOSFET capable of VHF operation, where conductive gate 80, formed of either Al, Al containing Si, or Al containing Cu and Si, or any other compatible gate material, is formed over drain 82 with a first thickness of oxide 86 therebetween. In one example, oxide 86 is 1 μm (10,000 Å) thick. Gate 80 is also formed over P body regions 88 with a second thickness of oxide 90 therebetween. In one embodiment, oxide 90 is 90 nm (900 Å) thick. Also shown in Fig. 5 is N+ source region 92 and P+ body contact region 94, with conductive source contact 96 shorting together N+ source region 92 and P+ body contact region 94. N+ drain contact 95 is shown contacting a bottom surface of drain 82.

Since oxide layer 86 is significantly thicker than oxide layer 90, the capacitance between gate 80 and drain 82 will be relatively low due to this increased dielectric thickness, while the capacitance between gate 80 and source region 92 will not significantly change. The thickness of gate oxide layer 90 is dictated by design considerations to provide a desired threshold voltage $V_T$ and dielectric breakdown voltage.

Lateral dimensions of the various above-described regions for one embodiment are shown in Fig. 5.

Thus, in the embodiment of Fig. 5, a gate-to-source voltage $V_{GS}$ will cause the field created between gate 80 and N+ source region 92 and between gate 80 and P- body region 88 to invert the channel region within P- body region 88, causing an ohmic channel to be created between N+ source region 92 and N- drain 82. This inversion of P- body region 88 is primarily due to the field created by the portion of gate 80 located above thin oxide layer 90. The portion of gate 80 overlying thick oxide layer 86 has a reduced effect on the conductance of the MOSFET and provides shielding over drain 82.

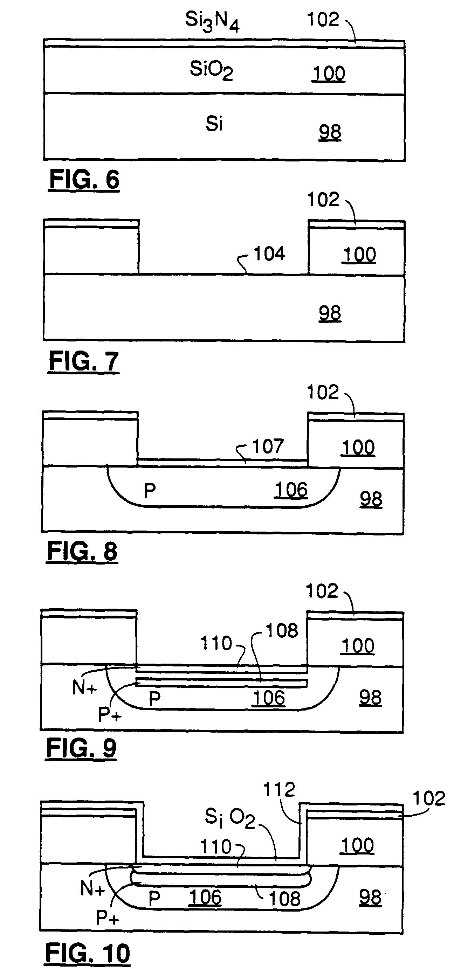

Figs. 6-12 illustrate a method to form the structure of Fig. 5.

In Fig. 6, an epitaxial layer 98 of N-type conductivity, having an impurity concentration of approximately 3 x 10E15 atoms/cm$^3$ to achieve a breakdown voltage of between 80 to 100 V is deposited on an N+ substrate and has formed over it silicon dioxide layer 100 having a thickness of preferably 1 μm (10,000 Å).

Oxide layer 100 would be formed to have a thickness of 700 nm (7,000 Å) for embodiments using two metal layers (a gate layer and a source layer). This two metal layer embodiment is illustrated on the right hand side of Fig. 5.

Oxide layer 100 may be formed by wet oxidation at approximately 1,000°C for 3-5 hours. Over oxide layer 100 is then formed silicon nitride layer 102 by a chemical vapor deposition (CVD) process at approximately 790°C to achieve a thickness of approximately 100 nm (1,000 Å).

In Fig. 7, oxide layer 100 and silicon nitride layer 102 are etched by using a conventional positive photoresist, contact masking technique and an anisotropic etch to expose portion 104 of substrate 98. In a preferred embodiment, a Lam™ dry etcher is used. The exposed portion 104 of substrate 98 is to coincide with the desired location of the body-source diffusion.

In Fig. 8, boron is implanted into substrate 98 through exposed portion 104 and diffused to form P body region 106. In the preferred embodiment, boron ions are implanted at an energy of 70KeV with a dosage of $6 \times 10E13/cm^2$. The exposed silicon is then oxidized for 30 minutes at 900°C in a dry $O_2$ atmosphere to form oxide layer 107 in order to prevent damage to the substrate during a subsequent diffusing process conducted in an $N_2$ atmosphere. The implanted ions are diffused by a ramp up and dwell diffusing process, where the temperature of the wafer is ramped from 900°C to 1,100°C at a rate of approximately 8°C/minute and held for approximately 2.5 hours and then ramped down to 900°C for one hour (including ramping time) in an $N_2$ atmosphere, to form P body region 106 having a depth of approximately two microns. The required characteristics of P body region 106 will depend on the desired breakdown voltage of the device and will be readily apparent to one of ordinary skill in the art.

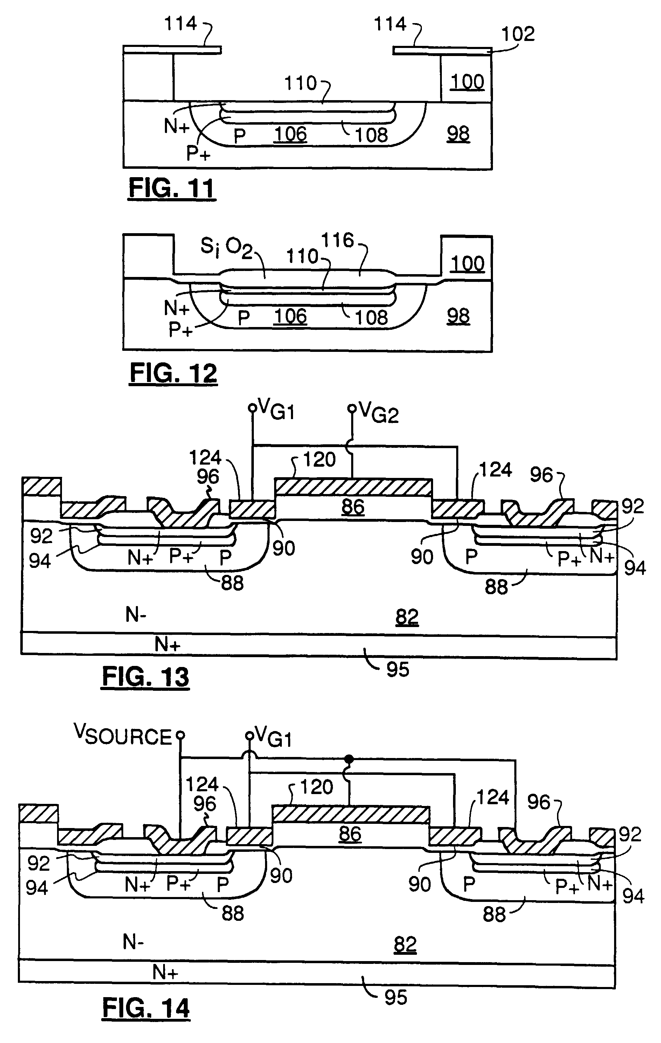

In Fig. 9, an additional boron implant is conducted to form P+ contact region 108 within P body region 106. In the preferred embodiment, boron ions are implanted at an energy of approximately 100KeV with a dosage of 10E15 to $10E16/cm^2$. The implant energy is calculated to form P+ region 108 at a depth below the surface of substrate 98 where it is desired to have P+ region 108 interface with a subsequently formed source region. Next, the wafer is dipped in a 10:1, $H_2O$:HF solution for approximately 45 seconds to remove oxide layer 107, and arsenic is implanted to form N+ source region 110 at the surface of substrate 98. In the preferred embodiment, arsenic ions are implanted at an energy of approximately 40KeV with a dosage of $10E16/cm^2$.

In Fig. 10, silicon dioxide layer 112 is deposited at 400°C over the surface of the wafer to a thickness of approximately 50 nm (500 Å) to prevent any out-diffusing of arsenic ions forming source region 110. The impurities within N+ source region 110 and P+ body contact region 108 are then driven-in for approximately 30 minutes at approximately 1,000°C so that N+ source region 110 extends approximately 0.3 microns beneath the surface of substrate 98. During this drive-in period, P+ body contact region 108 and P body region 106 also diffuse.

In Fig. 11, an oxide etchant is used to remove oxide layer 112 and a portion of oxide layer 100 so as to leave overhanging silicon nitride portion 114. In the preferred embodiment to conduct this etching, the wafer is immersed in any oxide etch solution with a known and controlled etch rate. For example, six parts $H_2O$ to one part ammonium fluoride may be used at 25°C for a period calculated to create the desired overhanging of nitride portion 114 relative to P body 106. For the diffusion process previously described, a 1.4 micron overhang of nitride portion 114 is satisfactory.

In Fig. 12, the wafer is immersed in hot phosphoric acid (or an equivalent thereof) at a temperature of approximately 160°C for one hour to remove silicon nitride portion 114 and the remainder of silicon nitride layer 102 over oxide layer 100. As a precaution against arsenic outgassing, the wafer is gradually ramped up to a temperature of 920° in a tube furnace for approximately 15 minutes in a dry $O_2$ atmosphere to form a thin layer of oxide 5-10 nm (50-100 Å) thick. Silicon dioxide layer 116 is then grown over the surface of the wafer at approximately 920°C for approximately 25 minutes in an atmosphere of wet $O_2$ to a thickness of 250-300 nm (2500-3000 Å) over N+ source region 110. An increased thickness of oxide layer 116 is inherently formed over N+ source region 110. The portion of oxide layer 116 over P body region 106, forming the gate oxide, will be approximately 900 Å at this stage.

Next, as shown in Fig. 5, a portion of oxide layer 116 over source region 110 is etched to expose a portion of source region 110. In an alternative embodiment, an additional etch is conducted to etch source region 110 through to expose P+ body contact region 108. A conductive metal layer is then formed over the surface of the wafer by the deposition of either Al, Al containing Si, Al containing Cu and Si, or any other conventional metal layer to a thickness of approximately one micron. In the VHF application, aluminum, copper, and silicon are sputtered over the surface of the wafer. A metal layer containing Si is preferred to minimize migration of the metal atoms into the silicon substrate. For higher frequency applications, metal source contact 96 preferably comprises a WTi barrier layer in contact with the source region overlaid by approximately 1 micron of Au.

The resulting metal layer is then masked and etched to form source contact 96 and gate 80 as shown in Fig. 5. Source contact 96 contacts N+ source region 92 and also contacts P+ contact region 94 through N+ source region 92, due to source region 92 and P+ contact region 94 being so highly doped as to be in ohmic contact with each other. Ohmic contact is further enhanced by implant damage to the crystalline substrate.

In an alternative example, source region 92 is anisotropically etched completely through in the contact area so that source contact 96 directly contacts both P+ body contact region 94 and N+ source region 92.

Any embodiment herein may be formed with a tungsten (W) or refractory metal silicide layer deposited prior to the formation of source contact 96 to prevent migration of atoms and/or to reduce contact resistance.

In practice, it is desirable to form source contact 96 close to the channel region to minimize on-resistance.

The method described in Figs. 6-12 and Fig. 5 forms a MOSFET having a low gate-drain capacitance $C_{GD}$, wherein source region 92, body contact region 94, and body region 88 are formed self-aligned with the drain edge portion of gate 80. In this method to form a VHF MOSFET, there are no critical alignment tolerances, which makes this above described process one that will inherently result in a high yield of MOSFETs on a wafer.

In the structure of Fig. 5, the portion of gate 80 formed over thick oxide portion 86 is connected to the portion of gate 80 formed over thin oxide portion 90 by a vertical gate portion. In a variation of the MOSFET structure of Fig. 5, the metal layer is formed by a method which will intentionally provide poor step coverage, such as by an evaporation process, so that the vertical portion of gate 80 will be relatively thin compared to the horizontal portions of gate 80. Such a resulting structure, having relatively thin vertical portions of gate 80 is then isotropically etched using a commercially available wet aluminum etch containing phosphoric acid, assuming gate 80 is composed of A1, so as to isolate the portion of gate 80 formed above thick oxide portion 86 from the portion of gate 80 formed above thin oxide portion 90. This is shown in Fig. 13, where upper gate 120 and lower gates 124 result. The remaining elements in the MOSFET of Fig. 13 are similar to those in Fig. 5 and are formed using a process similar to that described with respect to Fig. 5.

In all the examples described herein, for higher frequency operation, the source contact is preferably an overlay metal (such as shown on the right hand side of Fig. 5). This allows P body region 88 to be relatively narrow (~10 microns) for low drain-to-source capacitance $C_{DS}$. The various figures do not incorporate a two metal layer for simplicity.

In the MOSFET structure of Fig. 13, gate voltage is applied to lower gates 124, while a separate voltage is applied to upper gate 120. A positive voltage applied to upper gate 120 will make upper gate 120 effective in creating additional carriers in the N- drain 82 and increasing the current handling capability of the MOSFET. A negative voltage on upper gate 120 will increase the breakdown voltage of the MOSFET.

In Fig. 14, a structure identical to Fig. 13 is shown except that upper gate 120 is connected to the source voltage instead of to an upper gate voltage. Thus, in this configuration, upper gate 120 acts as a field plate for increasing the depletion region in drain 82 when the MOSFET is in its off state. This serves to enhance the breakdown voltage of the MOSFET.

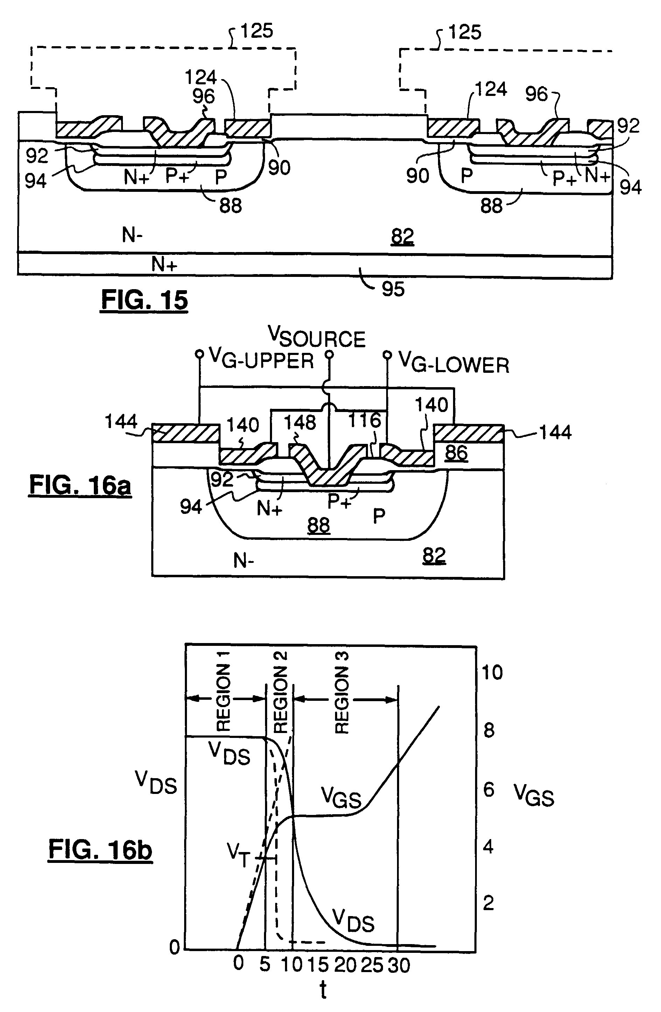

In an alternative, shown in Fig. 15, upper metal gate 120 of Fig. 13 is removed using a wet etch process. As shown in Fig. 15, mask 125, shown in dashed outline, is first formed to expose a center portion of the gate metal over oxide 86. The wet etch process removes the exposed metal and also removes the gate metal adjacent the exposed portion. Gate voltage is applied to gates 124 to invert the channel regions in P body regions 88.

In the highest speed application, shown in Fig. 16a, lower gate 140 is formed so as to only overlap a portion of the channel region in P body region 88, while upper gate 144 overlaps the remaining portion of the channel region in P body region 88. This configuration further reduces the $C_{GD}$ of the MOSFET, since lower gate 140 is relatively physically distant from drain 82. In this configuration, the field generated by upper gate 144 in conjunction with the field created by lower gate 140 is used to invert the channel region in P body region 88 to form an ohmic channel between N+ source region 92 and N-drain 82.

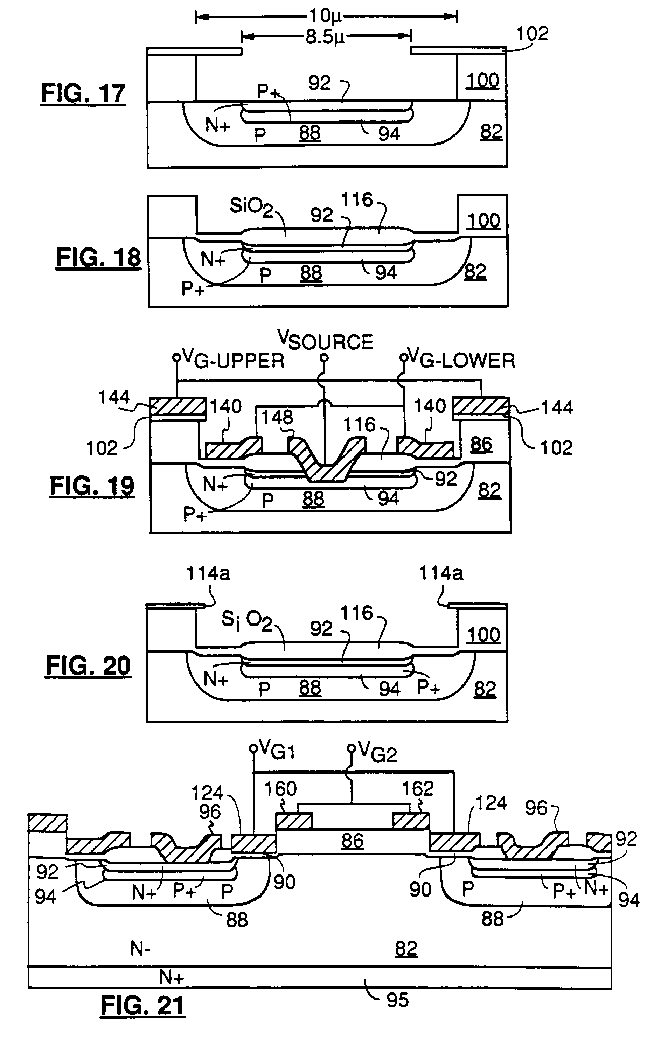

The structure of Fig. 16a is formed using a method similar to that described with respect to Fig. 5, except that after drive-in of N+ source region 92 and P+ contact region 94, the oxide etch, previously discussed with respect to Fig. 11, is conducted for less time so as to etch away less of oxide layer 100 under silicon nitride layer 102. This is shown in Fig. 17. The terminating portion of oxide layer 100 is located above an exposed portion of P body region 88 where it is desired for lower gate 140 and upper gate 144 to interface. Lateral dimensions of one embodiment are shown in Fig. 17.

In the step illustrated in Fig. 18, silicon nitride layer 102 is removed, and oxide layer 116 is grown.

As shown in Fig. 16a, oxide 116 is etched, and source region 92 and body contact region 94 are optionally etched in order to short these regions together by a metal source contact. A metal conductive layer is then deposited, preferably by evaporation, so as to provide a metal layer having poor step coverage. This metal layer is then masked and isotropically etched so as to form upper gate 144, lower gate 140, and, optionally, source contact 148. Source contact 148 may also be formed later through an opening in a subsequently deposited oxide layer and oxide portion 116, resulting in a two layer metal embodiment, preferable for high frequency and high density devices.

In the structure of Fig. 16a, $C_{GD}$ has been virtually eliminated. Upper gate 144 may be connected to source region 92 through an alternating current (AC) short circuit, and the resulting drain-to-upper gate capacitance, which constitutes $C_{GD}$ (or $C_{rss}$) in the prior art MOSFETs of Figs. 1, 3 and 4, now appears in this invention as a part of $C_{DS}$. The dramatically improved switching characteristics of the new structure are shown by the broken lines in Fig. 16a superimposed on the gate charge characteristics graph of Fig. 2.

Fig. 19 illustrates an example which is a variation of the structure of Fig. 16a. In Fig. 19, upper gate 144 overhangs oxide portion 86. This structure has the advantage in that the channel region between N+ source 92 and drain 82 is completely overlapped by the combination of upper gate 144 and lower gate 140 so as to insure the inversion of the channel region. Further, the structure may be formed without any requirement for an isotropic etch to etch away a vertical portion of the metal layer initially connecting upper gate 144 to lower gate 140.

The method for forming the structure of Fig. 19 is similar to that for forming the structure of Fig. 5, except, in the process steps illustrated in Figs. 11 and 12 for forming the MOSFET of Fig. 5, nitride layer 102 is partially etched to 40-50% of its original thickness. This completely removes overhanging nitride portion 114. The sidewalls of oxide portion 100, shown in Fig. 20, is then re-etched 100-200 nm (1,000-2,000 Å) to create a new small overhanging nitride portion 114A. A metal layer is then deposited by, for example, evaporation, and a vertical portion is not formed on a sidewall of oxide layer 100. The resulting structure is masked and etched to form the structure of Fig. 19.

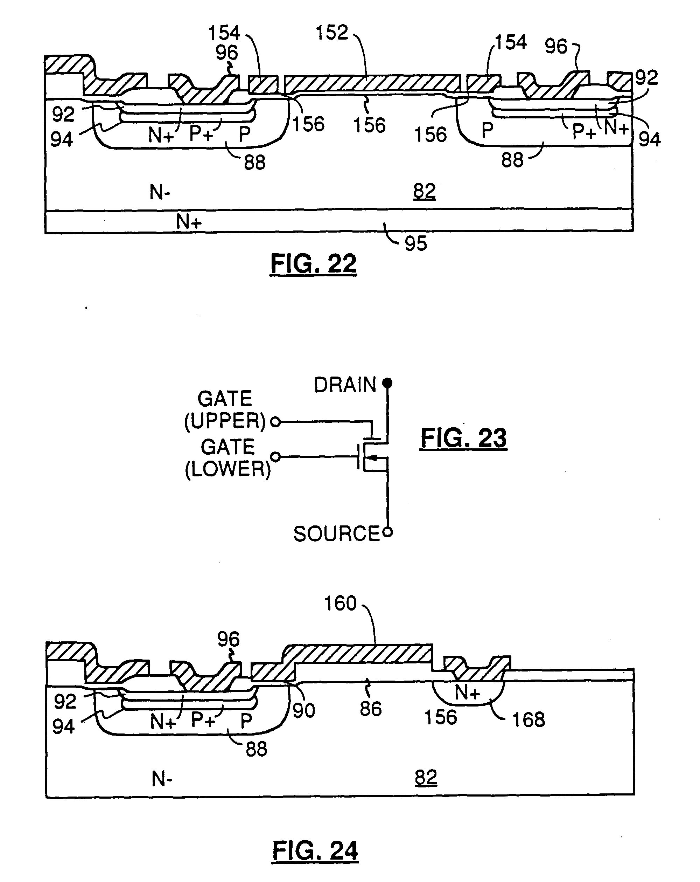

Fig. 21 shows an embodiment of the invention for higher frequencies. It is a variation of the MOSFETs having a separate upper gate. In Fig. 21 upper gates 160 and 162 are shown separated by a gap. This structure results in a lower drain-to-upper gate capacitance $C_{GD}$ due to less upper gate area over drain 82. High current capability is retained by the field created by upper gates 160 and 162. This split upper gate configuration may be used in any of the above-described embodiments including Fig. 5, where gate 80 overlying oxide 86 may be opened up to further reduce $C_{GD}$.

In the high frequency MOSFET of Fig. 21, source contact 96 is preferably comprised of a 200 nm (2,000 Å) WTi barrier layer under a 900 nm (9,000 Å) Au layer in an overlay (two layer metal) configuration. In an embodiment wherein a metal source contact is to directly contact both the P+ body contact region and the N+ source region, as shown in Fig. 19, platinum silicide is preferably used as a contact layer under the WTi to improve ohmic contact.

In one embodiment of the MOSFET of Fig. 21, the starting material is an N+ (antimony) <1-0-0> silicon substrate with an 8 micron epitaxial layer formed therein having a resistivity of 1.5 Ωcm.

Oxide layer 86 has a thickness of 700 nm (7,000 Å). Gate oxide 90 has a thickness of 80 nm (800 Å). The body opening mask through which body region 88 impurities are implanted is 8.5 microns wide. The space between gates 124 is approximately 25 microns. The source contact mask opening is 2 microns. The gate 124, 160, 162 length is approximately 2.5 μm.

The implant doses are as follows:

For P body region 88: 5 x 10E13/cm$^2$ at 70KeV using boron ions;
For P+ body contact region 94: 1 x 10E15/cm$^2$ at 100 KeV using boron ions; and,
For source region 92: 1 x 10E16/cm$^2$ at 40KeV using arsenic ions.

The channel length is approximately 1 micron, and the channel width is approximately 1100 microns.
The resulting structure has the following electrical properties:

$V_{TH}$ @ 25μA: 1.0-1.5V
$BV_{DSS}$ @ 250μA: 80V
gm @ 25mA, $V_D = 10V$: 0.025 mhos

$RD_{ON}$ @ $V_G = 10V$: 32 ohms
At $V_G = 0V$, $V_D = 28V$:
$C_{iss} \sim 1.25$ pf          $(C_{GS} + C_{GD})$
$C_{rss} \sim 0.0425$ pf          $(C_{GD})$
$C_{Oss} \sim 0.625$ pf          $(C_{DS} + C_{GD})$

When overlay metal is used, a Faraday shield is preferably connected to the source contact and placed between the gate bonding pad and the drain to prevent pad capacitance from becoming part of $C_{GD}$.

In additional examples, the upper gate described with respect to Figs. 13, 14, 16a, 19, and 21 is deposited on the same thickness of oxide as the lower gate and separated from the lower gate by a masking and etch process. A representative example is shown in Fig. 22, where gates 152 and 154 are formed over a same thickness of oxide 156. Further, both gates 152 and 154 may or may not overlie a portion of the channel region. The remaining elements in Fig. 22 are identical to those shown in Fig. 5.

Fig. 23 shows a new schematic representation of the resulting structures described herein which utilize a separate upper gate and lower gate.

Fig. 24 shows a lateral MOSFET, where gate portion 160 is formed over thick oxide 86, and gate portion 162 is formed over thin oxide 90. Gate portions 160 and 162 may be separated as described with respect to Fig. 13. The MOSFET of Fig. 24 is formed using steps similar to those used to form the vertical MOSFET of Fig. 5, except, in Fig. 23, N+ drain contact region 168 is formed in a top surface of substrate 82. Substrate 82 may be of an N or P type. If substrate 82 is of a P type, P body region 88 may be deleted.

Thus, an improved MOSFET has been described which exhibits a lower gate-to-drain capacitance $C_{GD}$, wherein source and body regions are precisely aligned with respect to a gate without the use of any critical masking steps, and wherein a parasitic bipolar transistor has been rendered inoperative. While particular embodiments of the present invention have been shown and described, it will be obvious to those skilled in the art that changes and modifications may be made without departing from this invention in its broader aspects. For example, all conductivity types may be made opposite to those specifically mentioned, and the various dimensions may be modified as necessary.

**Claims**

1. A MOSFET pair structure comprising:

a substrate (82) of a first conductivity type having a top surface and a bottom suface, the bottom surface of said substrate acting as a drain contact region (95) for said MOSFET pair structure;
a first and second body region (88) of a second conductivity type formed in said top surface of said substrate and separated from one another by a first area of said top surface of said substrate;

first and second source regions (92) of said first conductivity type formed in said top surface of said substrate and within respective ones of said body regions;

a conductive gate having an upper portion (160, 162) electrically separated from a first lower portion (124) and from a second lower portion (124), said first lower portion being insulated from a first channel region within said first body region between said first source region and a periphery of said first body region by an insulation layer (90) of a first thickness, said second lower portion being insulated from a second channel region within said second body region between said second source region and a periphery of said second body region by an insulation layer (90) of said first thickness, said upper portion being insulated from said first area of said top surface of said substrate by an insulation layer (86) of a second thickness, wherein said second thickness is greater than said first thickness, wherein said upper portion of said gate is split into a first upper portion (160) and a second upper portion (162), wherein neither said first upper portion nor said second upper portion overlies a central portion of said first area.

2. The MOSFET structure (figure 19) of claim 1

wherein said first lower portion (140) overlaps a first portion of said first channel region, and said first upper portion (144) overlaps a second portion of said first channel region, and wherein said second lower portion (140) overlaps a first portion of said second channel region, and said second upper portion (144) overlaps a second portion of said second channel region.

3. The MOSFET structure of claim 2 wherein said upper portion (144, 160, 162) is connected to receive an upper gate voltage ($V_{G\text{-}UPPER}$) for inverting said second portion of said first and second channel regions, and said first and second lower portions (124, 140) are connected to receive a separate lower gate voltage ($V_{G\text{-}LOWER}$) for inverting said first portion of said first and second channel regions.

4. The MOSFET structure of claim 1 or 2 wherein said upper portion (144, 160, 162) is connected to said source region through an AC short circuit.

5. The MOSFET structure of claim 1, 2, 3, or 4 wherein said upper portion (144) overhangs said insulation layer (100) of said second thickness.

6. A method of forming a MOSFET pair structure comprising the steps of:

forming a first and second body region (88) of a second conductivity type in a top surface of a substrate (82) of a first conductivity type and separating said first and second body regions from one another by a first area of said top surface of said substrate, a bottom surface of said substrate acting as a drain contact region (95) for said MOSFET pair structure;

forming first and second source regions (92) of said first conductivity type in said top surface of said substrate and within respective ones of said body regions; and

forming a conductive gate having an upper portion (160, 162) electrically separated from a first lower portion (124) and from a second lower portion (124),

said first lower portion being insulated from a first channel region within said first body region between said first source region and a periphery of said first body region by an insulation layer (90) of a first thickness,

said second lower portion being insulated from a second channel region within said second body region between said second source region and a periphery of said second body region by an insulation layer (90) of said first thickness,

said upper portion being insulated from said first area of said top surface of said substrate by an insulation layer (86) of a second thickness, wherein said second thickness is greater than said first thickness,

wherein said upper portion of said gate is split into a first upper portion (160) and a second upper portion (162) such that neither said first upper portion nor said second upper portion overlies a central portion of said first area.

7. The method of claim 6 wherein said step of forming said conductive gate (figure 19) comprises the steps of:

forming said conductive gate so that said first lower portion (140) overlaps a first portion of said first channel region, and said first upper portion (144) overlaps a second portion of said second channel region, and wherein said second lower portion (140) overlaps a first portion of said second channel region, and said second upper portion (144) overlaps a second portion of said second channel region.

8. The method of claim 6 or 7 further comprising the steps of:

> connecting said upper portion (144, 160, 162) to receive an upper gate voltage ($V_{G\text{-}UPPER}$) for inverting said second portion of said first and second channel regions; and
> connecting said first and second lower portions (124, 140) to receive a separate lower gate voltage ($V_{G\text{-}LOWER}$) for inverting said first portion of said channel regions.

9. The method of claim 6 or 7 further comprising the step of connecting said upper portion (144, 160, 162) to said source region (92) through an AC short circuit.

10. The method of claim 6, 7, 8, or 9 further comprising the step of forming said upper portion (144) so as to overhang said insulation layer (100) of said second thickness.

11. The MOSFET structure of claim 1, 2, 4, 5, or 6 wherein said upper portion (144, 160, 162) is connected to a fixed potential.

12. The method of claim 6, 7, 9, or 10 further comprising the step of connecting said upper portion (144, 160, 162) to a fixed potential.

**Patentansprüche**

1. MOSFET-Paar-Aufbau mit:

> Einem eine Oberseite und eine Unterseite aufweisenden Substrat (82) eines ersten Leitfähigkeitstyps, wobei die Unterseite des Substrats als Drain-Kontaktbereich (95) für den MOSFET-Paar-Aufbau wirkt,
> einem ersten und zweiten Körperbereich (88) eines zweiten Leitfähigkeitstyps, die in der Oberseite des Substrats gebildet und voneinander durch einen ersten Bereich der Oberseite des Substrats getrennt sind,
> ersten und zweiten Source-Bereichen (92) des ersten Leitfähigkeitstyps, die in der Oberseite des Substrats und innerhalb einem jeweiligen der Körperbereiche gebildet sind,
> einem leitenden Gate, das einen oberen Abschnitt (160, 162) aufweist, der elektrisch von einem ersten unteren Abschnitt (124) und von einem zweiten unteren Abschnitt (124) getrennt ist, wobei der erste untere Abschnitt von einem ersten Kanalbereich innerhalb des ersten Körperbereichs zwischen dem ersten Source-Bereich und einem Umkreis des ersten Körperbereichs durch eine Isolierschicht (90) einer ersten Dicke isoliert ist, wobei der zweite untere Abschnitt von einem zweiten Kanalbereich innerhalb des zweiten Körperbereichs zwischen dem zweiten Source-Bereich und einem Umkreis des zweiten Körperbereichs durch eine Isolierschicht (90) der ersten Dicke isoliert ist, wobei der obere Abschnitt von dem ersten Bereich der Oberseite des Substrats durch eine Isolierschicht (86) einer zweiten Dicke isoliert ist, wobei die zweite Dicke größer als die erste Dicke ist,
> wobei der obere Abschnitt des Gates in einen ersten oberen Abschnitt (160) und einen zweiten oberen Abschnitt (162) aufgeteilt ist, wobei weder der erste obere Abschnitt noch der zweite obere Abschnitt einen zentralen Abschnitt des ersten Bereichs überlagert.

2. MOSFET-Aufbau (Fig. 19) nach Anspruch 1, wobei der erste untere Abschnitt (140) einen ersten Abschnitt des ersten Kanalbereichs überlappt, und wobei der erste obere Abschnitt (144) einen zweiten Abschnitt des ersten Kanalbereichs überlappt, und
> wobei der zweite untere Abschnitt (140) einen ersten Abschnitt des zweiten Kanalbereichs überlappt, und wobei der zweite obere Abschnitt (144) einen zweiten Abschnitt des zweiten Kanalbereichs überlappt.

3. MOSFET-Aufbau nach Anspruch 2, wobei der obere Abschnitt (144, 160, 162) derart verbunden bzw. angeschlossen ist, daß er eine obere Gate-Spannung ($V_{G\text{-}UPPER}$) zum Invertieren des zweiten Abschnitts der ersten und zweiten Kanalbereiche empfängt, und die ersten und zweiten unteren Abschnitte (124, 140) so angeschlossen bzw. verbunden sind, daß sie eine getrennte untere Gate-Spannung ($V_{G\text{-}LOWER}$) zum Invertieren des ersten Abschnitts der ersten und zweiten Kanalbereiche empfangen.

4. MOSFET-Aufbau nach Anspruch 1 oder 2, wobei der obere Abschnitt (144, 160, 162) mit dem Source-Bereich durch einen Wechselstromkurzschluß verbunden ist.

5. MOSFET-Aufbau nach Anspruch 1, 2, 3 oder 4, wobei der obere Abschnitt (144) über die Isolierschicht (100) der zweiten Dicke vorspringt.

6. Verfahren zum Bilden eines MOSFET-Paar-Aufbaus, aufweisend die Schritte:

> Bilden eines ersten und zweiten Körperbereichs (88) eines zweiten Leitfähigkeitstyps, in einer Oberseite eines Substrats (82) eines ersten Leitfähigkeitstyps, und Trennen der ersten und zweiten Körperbereiche voneinander durch einen ersten Bereich der Oberseite des Substrats, wobei eine Unterseite des Substrats als Drain-Kontaktbereich (95) für den MOSFET-Paar-Aufbau wirkt,

Bilden erster und zweiter Source-Bereiche (92) des ersten Leitfähigkeitstyps in der Oberseite des Substrats und innerhalb jeweiliger der Körperbereiche, und Bilden eines leitenden Gates, das einen oberen Abschnitt (160, 162) aufweist, der von einem ersten unteren Abschnitt (124) und von einem zweiten unteren Abschnitt (124) getrennt ist,

wobei der erste untere Abschnitt von einem ersten Kanalbereich innerhalb des ersten Körperbereichs zwischen dem ersten Source-Bereich und einem Umkreis des ersten Körperbereichs durch eine Isolierschicht (90) einer ersten Dikke isoliert ist,

wobei der zweite untere Abschnitt von einem zweiten Kanalbereich innerhalb des zweiten Körperbereichs zwischen dem zweiten Source-Bereich und einem Umkreis des zweiten Körperbereichs durch eine Isolierschicht (90) der ersten Dicke getrennt ist,

wobei der obere Abschnitt von dem ersten Bereich der Oberseite des Substrats durch eine Isolierschicht (86) einer zweiten Dicke getrennt ist, wobei die zweite Dicke größer als die erste Dicke ist,

wobei der obere Abschnitt des Gates in einen ersten oberen Abschnitt (160) und einen zweiten oberen Abschnitt (162) derart getrennt ist, daß weder der erste obere Abschnitt noch der zweite obere Abschnitt einen zentralen Abschnitt des ersten Bereichs überlagert.

7. Verfahren nach Anspruch 6, wobei der Schritt, das leitende Gate (Fig. 19) zu bilden, die Schritte aufweist:

Bilden des leitenden Gates derart, daß der erste untere Abschnitt (140) einen ersten Abschnitt des ersten Kanalbereichs überlappt, und der erste obere Abschnitt (144) einen zweiten Abschnitt des zweiten Kanalbereichs überlappt, und

wobei der zweite untere Abschnitt (140) einen ersten Abschnitt des zweiten Kanalbereichs überlappt, und der zweite obere Abschnitt (144) einen zweiten Abschnitt des zweiten Kanalbereichs überlappt.

8. Verfahren nach Anspruch 6 oder 7, außerdem aufweisend die Schritte:

Verbinden bzw. Anschließen des oberen Abschnitts (144, 160, 162) zum Empfangen einer oberen Gate-Spannung ($V_{G\text{-}UPPER}$) zum Invertieren des zweiten Abschnitts der ersten und zweiten Kanalbereiche, und

Verbinden bzw. Anschließen der ersten und zweiten unteren Abschnitte (124, 140) zum Empfangen einer getrennten unteren Gate-Spannung ($V_{G\text{-}LOWER}$) zum Invertieren des ersten Abschnitts der Kanalbereiche.

9. Verfahren nach Anspruch 6 oder 7, außerdem aufweisend den Schritt, den oberen Abschnitt (144, 160, 162) mit dem Source-Bereich (92) durch einen Wechselstromkurzschluß zu verbinden.

10. Verfahren nach Anspruch 6, 7, 8 oder 9, außerdem aufweisend den Schritt, den oberen Abschnitt (144) derart zu bilden, daß er über die Isolierschichtt (100) der zweiten Dicke vorsteht.

11. MOSFET-Aufbau nach Anspruch 1, 2, 4, 5 oder 6, wobei der obere Abschnitt (144, 160, 162) mit einem festen Potential verbunden ist.

12. Verfahren nach Anspruch 6, 7, 9 oder 10, außerdem aufweisend den Schritt, den oberen Abschnitt (144, 160, 162) mit einem festen Potential zu verbinden.

**Revendications**

1. Structure d'une paire de MOSFET (transistor à effet de champ à grille isolée par oxyde métallique) comprenant :

un substrat (82) d'un premier type de conductivité ayant une surface supérieure et une surface inférieure, la surface inférieure de ce substrat faisant office de région de contact de drain ou borne (95) pour cette structure de paire de MOSFET ;

une première et une seconde région de corps (88) d'un second type de conductivité, formées dans la surface supérieure du substrat et séparées l'une de l'autre par une première zone de surface supérieure du substrat ;

des première et seconde régions de source (92) du premier type de conductivité, formées dans la surface supérieure du substrat et dans les régions respectives de ces régions de corps ;

une porte conductrice ayant une portion supérieure (160, 162) séparée électriquement d'une première portion inférieure (124) et d'une seconde portion inférieure (124), cette première portion inférieure étant isolée d'une première région de canal dans la première région de corps entre la première région de source et une périphérie de la première région de corps par une couche d'isolation (90) d'une première épaisseur, cette seconde portion inférieure étant isolée d'une seconde région de canal à l'intérieur de la seconde région de corps entre la seconde région de source et une périphérie de la seconde région de corps par une couche d'isolation (90) de la première épaisseur, cette portion supérieure étant isolée de la première zone de la surface supérieure du substrat par une couche d'isolation (86) d'une seconde épaisseur dans laquelle la seconde épaisseur est supérieure à la première épaisseur ; structure dans laquelle la portion supérieure de la porte est divisée en une première portion supérieure (160) et en une seconde portion supérieure (162), dans laquelle ni la première portion supérieure, ni la seconde portion supérieure ne recouvrent une portion centrale de cette première zone.

2. Structure de MOSFET (figure 19) de la revendication 1, dans laquelle la première portion inférieure (140) recouvre une première portion de la première région de canal, et la première portion supérieure (144) recouvre une seconde portion de la première région de canal, et

dans laquelle la seconde portion inférieure (140) recouvre une première portion de la seconde région de canal, et la seconde portion supérieure (144) recouvre une seconde portion de la seconde région de canal.

3. Structure de MOSFET selon la revendication 2, dans laquelle la portion supérieure (144, 160, 162) est connectée pour recevoir une tension de porte supérieure ($V_{G-UPPER}$) pour inverser la seconde portion des première et seconde régions de canal, et les première et seconde portions inférieures (124, 140) sont connectées pour recevoir une tension de porte inférieure séparée ($V_{G-LOWER}$) pour inverser la première portion des première et seconde régions de canal.

4. Structure de MOSFET selon la revendication 1 ou 2, dans laquelle la portion supérieure (144, 160, 162) est connectée à la région de source par un court-circuit au courant alternatif.

5. Structure de MOSFET selon la revendication 1, 2, 3 ou 4, dans laquelle la portion supérieure (144) est en surplomb par rapport à la couche d'isolation (100) de la seconde épaisseur.

6. Procédé pour la formation d'une structure de paire de MOSFET comprenant les étapes consistant à :

former une première et une seconde régions de corps (88) d'un second type de conductivité dans une surface supérieure d'un substrat (82) d'un premier type de conductivité et à séparer les première et seconde régions de corps l'une de l'autre par une première zone de la surface supérieure du substrat, une surface inférieure du substrat faisant office de région de contact de drain ou borne (95) pour cette structure de paire de MOSFET ; à former des première et seconde régions de source (92) du premier type de conductivité dans la surface supérieure du substrat et à l'intérieur des régions respectives des régions de corps ; et à former une porte conductrice ayant une portion supérieure (160, 162) séparée électriquement d'une première portion inférieure (124) et d'une seconde portion inférieure (124), la première portion inférieure étant isolée d'une première région de canal à l'intérieur de la première région de corps entre la première région de source et une périphérie de la première région de corps par une couche d'isolation (90) d'une première épaisseur, la seconde portion inférieure étant isolée d'une seconde région de canal à l'intérieur d'une seconde région de corps entre la seconde région de source et une périphérie de la seconde région de corps par une couche d'isolation (90) de la première épaisseur, la portion supérieure étant isolée de la première zone de la surface supérieure du substrat par une couche d'isolation (86) d'une seconde épaisseur, dans laquelle la seconde épaisseur est supérieure à la première épaisseur, dans laquelle la portion supérieure de la porte est divisée en une première portion supérieure (160) et en une seconde portion supérieure (162) de telle sorte que ni la première portion supérieure, ni la seconde portion supérieure ne recouvrent une portion centrale de la première zone.

7. Procédé selon la revendication 6, dans lequel l'étape consistant à former la porte conductrice (figure 19) comprend les étapes consistant à :

former la porte conductrice de telle sorte que la première portion inférieure (140) chevauche une première portion de la première région de canal, et cette première portion supérieure (144) chevauche une seconde portion de la seconde région de canal, et dans laquelle la seconde portion inférieure (140) chevauche une première portion de la seconde région de canal, et cette seconde portion supérieure (144) chevauche une seconde portion de la seconde région de canal.

8. Procédé selon la revendication 6 ou 7, comprenant de plus les étapes consistant à :

   connecter la portion supérieure (144, 160, 162) pour recevoir une tension de porte supérieure ($V_{G-UPPER}$) pour inverser la seconde portion des première et seconde régions de canal ; et connecter les première et seconde portions inférieures (124, 140) pour recevoir une tension de porte inférieure séparée ($V_{G-LOWER}$) pour inverser la première portion des régions de canal.

9. Procédé selon la revendication 6 ou 7, comprenant de plus l'étape consistant à connecter la portion supérieure (144, 160, 162) à la région de source (92) par un court-circuit au courant alternatif.

10. Procédé selon la revendication 6, 7, 8 ou 9, comprenant de plus l'étape consistant à former la portion supérieure (144) de façon à se trouver en surplomb par rapport à la couche d'isolation (100) de la seconde épaisseur.

11. Structure de MOSFET selon la revendication 1, 2, 4, 5 ou 6, dans laquelle la portion supérieure (144, 160, 162) est connectée à un potentiel fixe.

12. Procédé selon la revendication 6, 7, 9 ou 10, comprenant de plus l'étape consistant à connecter la portion supérieure (144, 160, 162) à un potentiel fixe.

SOURCE     GATE     SOURCE

$V_G$

36    $C_{GD}$    38    36

$C_{GS}$       $C_{GS}$

30   n+   p      p   30   n+

p+               p+

34    34

$C_{DS}$    44    40    $C_{DS}$   n-

n+

20

**FIG. 1a**
(PRIOR ART)

$+V_{DD}$
DRAIN

DRAIN    $I_D$

$I_{C_{GD}}$

$C_{GD}$

**FIG. 1b**
(PRIOR ART)

$C_{DS}$    $V_{DS}$

$I_G$   50

GATE   $V_{GS}$   $C_{GS}$   52    NPN

SOURCE

REGION 1   REGION 2   REGION 3

10

8

$V_{DS}$

$V_{DS}$     $V_{GS}$    6   $V_{GS}$

**FIG. 2**
(PRIOR ART)

$V_T$    4

2

$V_{DS}$

0

0   5   10 15 20 25 30

t

**FIG. 3**
(PRIOR ART)

**FIG. 4**
(PRIOR ART)

**FIG. 5**

$Si_3N_4$    102

$SiO_2$    100

Si    98

**FIG. 6**

102

104    100

98

**FIG. 7**

102

107    100

P    106    98

**FIG. 8**

102

110   108    100

N+    P    106    98

P+

**FIG. 9**

112    102

$Si O_2$

110    100

N+    P   106   108    98

P+

**FIG. 10**

**FIG. 11**

114    114    102

110    100

N+    98
P    106    108
P+

**FIG. 12**

S$_i$O$_2$    110    116    100

N+    98
P    106    108
P+

**FIG. 13**

V$_{G1}$    V$_{G2}$

124    120    124    96
96
86    92
92    90    90
94    N+ P+ P    P    P+ N+    94
88    88

N-    82
N+
95

**FIG. 14**

V$_{SOURCE}$    V$_{G1}$

124    120    124    96
96
86    92
92    90    90
94    N+ P+ P    P    P+ N+    94
88    88

N-    82
N+
95

**FIG. 15**

**FIG. 16a**

**FIG. 16b**

EP 0 513 185 B1

**FIG. 17**

$10\mu$
$8.5\mu$
102
92
100
P+
N+
P 88 94
82

**FIG. 18**

$SiO_2$ 92 116 100
N+
P 88 94
P+ 82

**FIG. 19**

$V_{SOURCE}$
$V_{G-UPPER}$ $V_{G-LOWER}$
144 140 148 116 140 144
102 86 102
N+ 92
P+ P 88 94 82

**FIG. 20**

114a 114a
$S_iO_2$ 92 116 100
N+
P 88 94 P+ 82

**FIG. 21**

$V_{G1}$ $V_{G2}$
124 96 160 162 124 96
92 86 92
92 90 90
94 N+ P+ P P P+ N+ 94
88 88
N- 82
N+
95

18

**FIG. 22**

**FIG. 23**

**FIG. 24**